**Europäisches Patentamt**

**European Patent Office**

**Office européen des brevets**

(19)

(11) Veröffentlichungsnummer: **0 091 563**
**B1**

(12)

# EUROPÄISCHE PATENTSCHRIFT

(45) Veröffentlichungstag der Patentschrift:
26.02.86

(51) Int. Cl.⁴: **G 01 R 29/02**, G 01 N 29/04

(21) Anmeldenummer: 83102343.7

(22) Anmeldetag: 10.03.83

(54) **Verfahren und Vorrichtung zur Bestimmung des zeitlichen Impulsabstandes zweier elektrischer Impulse.**

(30) Priorität: **22.03.82 DE 3210436**

(43) Veröffentlichungstag der Anmeldung:
**19.10.83 Patentblatt 83/42**

(45) Bekanntmachung des Hinweises auf die Patenterteilung:
**26.02.86 Patentblatt 86/9**

(84) Benannte Vertragsstaaten:
**FR IT SE**

(56) Entgegenhaltungen:
**DE - B - 2 319 897**
**DE - B - 2 607 187**
**GB - A - 1 470 660**

(73) Patentinhaber: **Nukem GmbH, Rodenbacher Chaussee 6 Postfach 11 00 80, D-6450 Hanau 11 (DE)**

(72) Erfinder: **Sternberg, Walter, Hohe Mark Strasse 21, D-8755 Alzenau 3 (DE)**
Erfinder: **Schreyer, Fritz, Felgenstrasse 27, D-6456 Langenselbold (DE)**
Erfinder: **Ruth, Ursula, Gartenstrasse 13, D-6451 Ronneburg 1 (DE)**

(74) Vertreter: **Stoffregen, Hans-Herbert, Dr. Dipl.-Phys. et al, Patentanwälte Strasse & Stoffregen Salzstrasse 11a Postfach 2144, D-6450 Hanau/Main 1 (DE)**

## Beschreibung

Die Erfindung bezieht sich auf ein Verfahren und eine Vorrichung zur Bestimmung des zeitlichen Impulsabstandes zweier symmetrischer formähnlicher elektrischer Impulse, die beim Erreichen einstellbarer Schwellenwerte Zeitmeßvorgänge auslösen, die Meßwerte ergeben, aus denen der Impulsabstand berechnet wird.

Ein Verfahren uno eine Vorrichtung dieser Gattung sind bereits bekannt (DE-AS 26 07 187). Bei Uberschreitung des eingestellten Schwellenwertes durch den ersten Impuls wird nach diesem bekannten Verfahren ein erster Zeitmeßvorgang eingeleitet, der bei Unterschreitung des gleichen eingestellten Schwellenwertes durch den abfallenden Teil des Impulses beendet wird. Der zweite Impuls löst einen zweiten Zeitmeßvorgang aus, der in gleicher Weise abläuft. dritter Zeitmeßvorgang beginnt beim Unterschreiten des Schwellenwertes durch den abfallenden Teil des ersten Impulses und endet bei Uberschreitung des Schwellenwertes durch den ansteigenden Teil des zweiten Impulses. Während der Zeitmeßvorgänge werden periodische Zählimpulse aufsummiert. Die Frequenz der Zählimpulse ist bei den ersten beiden Zeitmeßvorgängen halb so groß wie beim dritten Zeit-meßvorgang. Der Impulsabstand wird durch Summierung der während der drei Zeitmeßvorgänge erhaltenen Zählimpulse bestimmt.

Das bekannte Verfahren wird bei der Ultraschall-Werkstoffprüfung eingesetzt, um über die von S allimpulsen hervorgerufenen elektrischen Impulse Schallaufzeiten, Schallgeschwindigkeiten, Materiallängen oder Materialdicken festzustellen. Es können insbesondere auch Laufzeiten aufeinanderfolgender Rückwandechos genauer ermittelt werden.

Der Erfindung liegt die Aufgabe zugrunde, ein Verfahren und eine Vorrichtung der eingangs erläuterten Gattung derart weiterzuentwickeln, daß mit geringerem Aufwand eine höhere Meßgenauigkeit insbesondere bei Impulsen relativ kurzer Dauer, erzielt wird.

Die Aufgabe wird erfindungsgemäß dadurch gelöst, daß eine erste Zeitdauer, die von dem Zeitpunkt des Erreichens des einstellbaren Schwellenwertes durch den gegen den Scheitelwert strebenden Teil des ersten Impulses bis zu dem Zeitpunkt des Erreichens des einstellbaren Schwellenwertes durch den gegen den Scheitelwert strebenden Teil des zweiten Impulses dauert, und eine zweite Zeitdauer, die von dem Zeitpunkt des Erreichens des einstellbaren Schwellenwertes durch den vom Scheitelwelt gegen Bezugspotential strebenden Teil des ersten Impulses bis zu dem zeitpunkt des Erreichens des einstellbaren Schwellenwertes durch den vom Scheitelwert gegen Bezugspotential strebenden Teil des zweiten Impulses dauert, digital gemessen werden, daß danach die Meßwerte der Zeitdauer aufsummiert werden und daß anschließend die Summe durch Zwei dividiert wird. Dieses Verfahren kommt ohne Messung der Impulsbreiten des ersten und zweiten Impulses aus und benötigt lediglich zwei Zeitmeßvorgänge Damit stehen gegenüber dem bekannten Verfahren längere Meßzeiten zur Verfügung. Werden bei dem bekannten Verfahren und bei dem vorstehend beschriebenen Verfahren Meßeinrichtungen verwendet, die hinsichtlich ihres Auflösungsvermögens übereinstimmen, dann ergibt sich bei dem vorstehend beschriebenen Verfahren wegen der längeren Meßzeiten ein kleinerer Meßfehler. Während bei dem bekannten Verfahren die Dauer der Impulse einen großen Einfluß auf die Meßgenauigkeit hat, ist diese Schwierigkeit bei dem vorstehend erläuterten Verfahren beseitigt. Daher ermöglicht das Verfahren die Feststellung von Impulsabständen in einem größeren Dynamikbereich.

Vorzugsweise werden die erste und zweite Zeitdauer durch Aufsummieren periodischer Taktimpulse von gleicher Frequenz gemessen. Es ist also nur eine Taktimpulsquelle erforderlich. Eine Division der Summe der Zählwerte kann eingespart werden, indem bei der Auswertung der Summe berücksichtigt wird, daß die periode der Taktimpulse zwei Meßeinheiten entspricht.

Eine Vorrichtung zur Durchführung des oben beschriebenen Verfahrens besteht erfindungsgemäß darin, daß ein Empfänger für die Impulse über Torschaltungen, die die zu messenden Impulse freigeben, an nachgeschaltete Komparatoren angeschlossen ist, die jeweils bei Erreichen des Schwellenwertes durch die gegen die Scheitelwerte oder von den Scheitelwerten gegen Nullpotential verlaufenden Teile der Impulse ihr binäres Ausgangssignal ändern, daß die Ausgangssignale der Komparatoren je an einen Freigabeeingang eines Zählers angeschlossen sind, daß die Zähleingänge der Zähler von Taktimpulsen eines Taktgenerators beaufschlagt sind und daß den Ausgängen der Zähler ein Addierer und eine Dividieranordnung nachgeschaltet sind. Diese Anordnung zeichnet sich durch ihren geringen Aufwand aus.

Weitere Merkmale sind den Unteransprüchen zu entnehmen.

Die Erfindung wird im folgenden anhand eines in einer Zeichnung dargestellten Ausführungsbeispiels näher erläutert, aus dem sich weitere Merkmale sowie Vorteile ergeben.

Es zeigen:

Fig. 1 ein Diagramm des zeitlichen Verlaufs zweier aufeinanderfolgender Impulse,

Fig. 2 ein Schaltbild einer Vorrichtung zur Bestimmung des zeitlichen Impulsabstandes zweier aufeinanderfolgender Impulse,

Fig. 3 ein Diagramm des zeitlichen Verlaufs von bei der Vorrichtung gemäß Fig. 2 auftretenden Signalen.

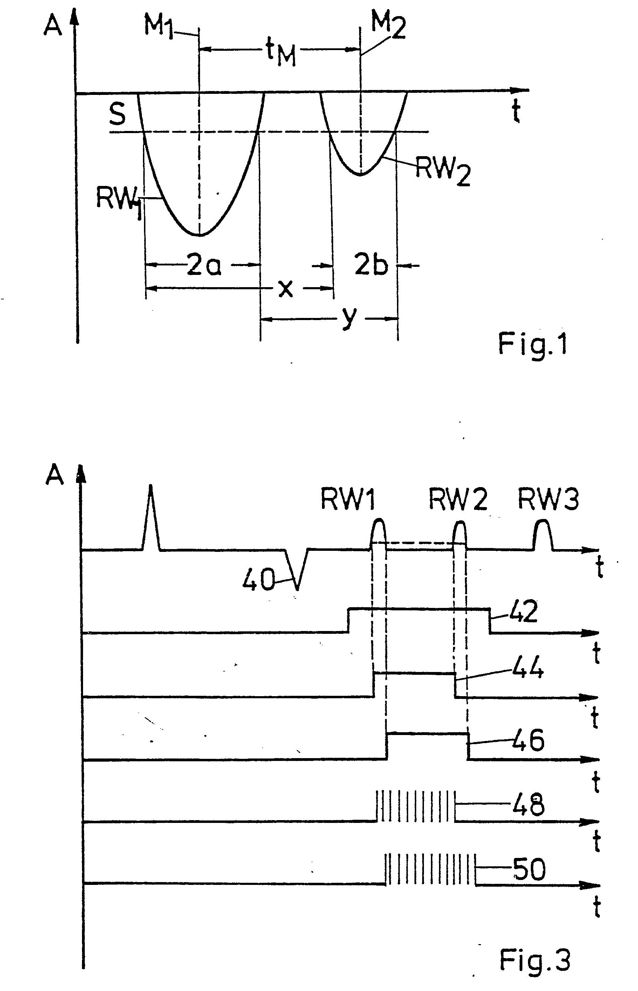

In Fig. 1 sind zwei von einer Ultraschall-Prüfeinrichtung hervorgerufene Rückwandechoimpulse RW1 und RW2 nach der Umwandlung in entsprechende elektrische Signale dargestellt. Die Rückwandechoimpulse RW1 und RW2 werden auf einen einstellbaren Schwellenwert S hin überwacht. Erreicht der erste Rückwandechoimpuls RW1 den Schwellenwert S, dann wird ein erster Zeitmeßvorgang eingeleitet, der auch nach dem Ende des Rückwandechoimpulses RWI noch andauert. Der erste Zeitmeßvorgang wird immer dann abgebrochen, wenn der zweite Rückwandechoimpuls RW2 den Schwellenwert S erreicht hat. Die Dauer des ersten Zeitmeßvorgangs ist in Fig. 1 mit X bezeichnet.

Sobald der Rückwandechoimpuls RW1 mit seinem gegen den pegel Null abfallenden Teil den Schwellenwert S erreicht, wird ein zweiter Zeitmeßvorgang eingeleitet, der über den Abstand zwischen den beiden Impulsen RW1 und RW2 hinweg andauert. Der zweite Zeitmeßvorgang, dessen Dauer in Fig. 1 mit y bezeichnet ist, wird vom zweiten Rückwandechoimpuls RW2 abgebrochen, wenn dessen gegen den Pegel Null abfallender Teil den Schwellenwert S erreicht hat.

Die Breite des ersten Rückwandechoimpulses RW1 in Höhe des Schwellenwertes S ist in Fig. 1 mit 2a bezeichnet. In entsprechender Weise ist die Breite des zweiten Rückwandechoimpulses RW2 mit 2b bezeichnet. Der zeitlich in Fig. 1 mit t bezeichnete Abstand zwischen den Mitteln M1 und M2 der beiden Rückwandechoimpulse RW1 und RW2 ergibt sich nach folgender Beziehung aus den während der Zeitmeßvor-gänge erhaltenen Meßwerten für die jeweilige Dauer von x und y:

$$t_m = \frac{x + y}{2}$$

Diese Beziehung folgt daraus, daß
$x = a + t_m - b$ und $y = -a + t_m + b$
ist.

Es werden während der beiden Meßvorgänge die Werte x und y digital gemessen. Anschließend wird die Summe der Meßwerte x und y gebildet. Die Summe wird danach durch den Faktor 2 dividiert.

Nach dem vorstehend erläuterten prinzip können die Impulsabstände von symmetrischen formähnlichen Impulsen gemessen werden. Beispielsweise lassen sich die Impulslaufzeiten von Mehrfachechos erfassen.

Die Zeitvorgänge erstrecken sich über jeweils die Dauer x und y. Obwohl in der jeweiligen Dauer von x und y die Impulsbreite von RW1 und RW2 enthalten ist, braucht diese nicht gesondert gemessen zu werden. Damit entfallen insbesondere bei kurzen Impulsen RW1 und RW2 Meßvorgänge, die sich hinsichtlich der Meßzeit um Größen-ordnungen unterscheiden. Werden die Impulsabstände $t_m$ aus Meßwerten berechnet, die sich in Bezug auf die Meßzeit um Größenordnungen unterscheiden, dann bestimmt der im Zusammenhang mit der kurzen Meßzeit stehende Meßfehler den Meßfehler des Ergebnisses. Bei der oben erläuterten Meßmethode treten dagegen keine wesentlichen Unterschiede in den Dauern x und y auf. Daher lassen sich die verwendeten Meßeinrichtungen optimal im Hinblick auf den zulässigen Meß-fehler des Ergebnisses ausnutzen. Insbesondere können auch die Impulsabstände schmaler Impulse mit großer Genauigkeit ermittelt werden.

Im folgenden wird eine Vorrichtung zur Durchführung des oben erläuterten Meßverfahrens beschrieben. Diese Vorrichtung dient zur Messung des zeitlichen Abstandes von Rückwandechos bei der Ultraschallprüfung.

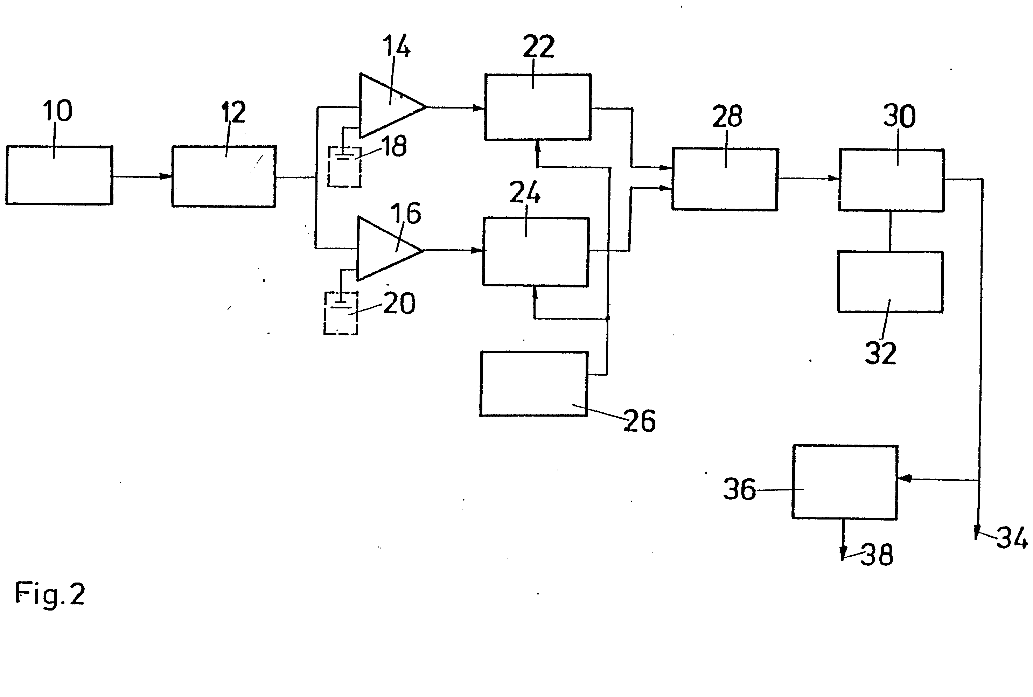

Eine Ultraschall-Prüfeinrichtung entsprechend Fig. 2 enthält einen nicht dargestellten Impulssender und einen Ultraschallempfänger 10. Impulssender und Ultraschallempfänger sind mit dem nicht dargestellten Prüfkopf der Ultraschall-Prüfeinrichtung verbunden. Der Ausgang des Ultraschallempfängers ist an Torschaltungen 12 angeschlossen. Die Torschaltungen 12 blenden aus den am Ausgang des Empfängers 10 anstehenden Signalen bestimmte Signale aus. Es handelt sich dabei um diejenigen Signale, zum Beispiel um die ersten beiden Rückwandechoimpulse RW1 und RW2, deren Abstand gemessen werden soll. Die Öffnungszeit der Torschaltungen 12 ist insbesondere dem Zeitraum angepaßt, in dem die zu messenden Impulse erwartet werden. Mit der Torschaltung 12 sind zwei Komparatoren 14, 16 verbunden. Die Komparatoren 14, 16 sind weiterhin an Einrichtungen 18, 20 angeschlossen, mit denen jeweils der Schwellenwert S vorgegeben wird.

Der Komparator 14 ist so ausgebildet, daß er auf den gegen den Scheitelwert ansteigenden Teil des ersten Rückwandechoimpulses RW1 beim Erreichen des Schwellenwertes S anspricht und dabei an seinem Ausgang ein binäres Signal abgibt, das seinen Wert ändert. Weiterhin spricht der Komparator 14 auf den gegen den Scheitelwert ansteigenden Teil des zweiten RückwandechoimPulses RW2 insofern an, als sein Ausgangssignal gegenüber dem vom Rückwandechoimpuls RW1 hervorgerufenen Wert beim Erreichen des Schwellenwertes S wiederum in den anderen binären Wert übergeht.

Der Komparator 16 zeigt ein ähnliches Verhalten. Im Unterschied zum Komparator 14 spricht er auf den gegen den Nullpegel abfallenden Teil des ersten Rückwandechoimpulses RW1 beim Erreichen des Schwellenwertes S an und ändert dabei an seinem Ausgang die binäre Wertigkeit des Ausgangssignals. Ferner spricht der Komparator 16 auf den gegen den Nullpegel abfallenden Teil des zweiten Rückwandechoimpulses RW2 beim Erreichen des Schwellenwertes S an und ändert dabei wiederum die binäre Wertigkeit seines Ausgangssignals.

Die Ausgangssignale der Komparatoren 14, 16 beaufschlagen als Steuersignale jeweils entsprechende Eingänge von Zählern 22, 24 deren Zähleingänge gemeinsam an einen Taktgenerator 26 angeschlossen sind, der Taktimpulse einer konstanten Frequenz abgibt. Die Ausgänge der beiden Zähler 22, 24 sind je mit einem der Summiereingänge eines Addierers 28 verbunden, dem ein Rechner 30, zum Beispiel ein Mikrocomputer, nachgeschaltet ist. In dem Rechner 30 werden über eine Eingabe 32 weitere Daten, zum Beispiel die Schallgeschwindigkeit des zu prufenden Werkstoffs, eingegeben. Der Rechner 30 speist eine Digitalausgabe 34 und ferner über einen Digital-Analog-Umsetzer 36 eine Analogausgabe 38.

Am Empfänger 10 wird bei der Ultraschall-Prüfung am Sendeimpuls aus dem Ultraschallsender das Eintrittsecho 40 in das Prüfstück, der erste Rückwandechoimpuls RW1, der zweite Rückwandechoimpuls RW2 und der dritte Rückwandechoimpuls RW3 empfangen. Weitere Rückwandechoimpulse sind in Fig. 3 nicht dargestellt.

Eine nicht dargestellte Steuerlogik, die zum Beispiel durch den Rechner 30 realisiert ist, gibt den Torschaltungen 12 eine Blendendauer 42 vor, während der die Rückwandechoimpulse RW1 und RW2 über die Torschaltungen 12 zu den Komparatoren 14 und 16 gelangen können. Es werden daher nur die ersten beiden Rückwandechoimpulse der Messung unterzogen.

Wenn der Schwellenwert S vom ersten Rückwandechoimpuls RW1 erreicht wird, tritt am Komparatorausgang ein binäres Steuersignal 44 auf, das zum Beispiel den Binärwert "1" hat. Das Steuersignal 44 endet dann, wenn der zweite Rückwandechoimpuls RW2 den Schwellenwert S erreicht hat. Das Steuersignal 44 fällt dabei ab, indem das Ausgangssignal des Komparators 14 den binären Wert "0" annimmt. Sobald der gegen den Nullpegel strebende Teil des Rückwandechoimpulses RW1 den Schwellenwert S erreicht hat, tritt am Ausgang des Komparators 16 ein Steuersignal 46 auf, das ebenfalls zum Beispiel den binären Wert "1" hat. Mit dem Rückgang des zweiten Rückwandechoimpulses RW2 nach der Uberschreitung des Scheitelwertes auf den Schwellenwert S endet das Steuersignal 46, indem der Ausgang des Komparators 16 auf den anderen binären Wert übergeht.

Die Signale 44, 46 öffnen jeweils während ihrer Dauer die Zähler 22, 24 für die Taktimpulse 48, 50 des Taktgenerators 26. Die Frequenz der Taktimpulse liegt im Megahertzbereich. Die Inhalte der Zähler 22, 24 können zum Beispiel in den ansteigenden Flanken der Steuersignale 44, 46 gelöscht und anschließend für die Taktimpulse freigegeben werden. Die Inhalt der Zähler 22, 24 werden mit den abfallenden Flanken der Signale 44, 46 zum Addierer 28 übertragen, der die Summe der Zählerinhalte bildet. Vom Addierer 28 empfängt der Rechner die Summe der Zählerinhalte und bestimmt daraus nach einer Division durch den Faktor 2 den Impulsabstand $t_m$

zwischen den Rückwandechoimpulsen RW1 und RW2. Anhand der über die Eingabe 32 vorgegebenen Schallgeschwindigkeit wird im Rechner 30 die Wandstärke des Prüflings bestimmt und über den Kanal 34 digital ausgegeben. Der Digital/Analog-Umsetzer 36 erzeugt einen analogen Wert der Wandstärke, der zum Beispiel auf einem Anzeigegerät dargestellt werden kann.

**Patentansprüche:**

1. Verfahren zur Bestimmung des zeitlichen Impulsabstandes zweier symmetrischer formähnlicher Impulse, die beim Erreichen einstellbarer Schwellenwerte Zeitmeßvorgänge auslösen, die Meßwerte ergeben, aus denen der Impulsabstand berechnet wird,
dadurch gekennzeichnet,
daß eine erste Zeitdauer (x), die von dem Zeitpunkt des Erreichens des einstellbaren Schwellenwertes (S) durch den gegen den Scheitelwert strebenden Teil des ersten Impulses (RW1 bis zu dem Zeitpunkt des Erreichens des einstellbaren Schwellenwertes (S) durch den gegen den Scheitelwert strebenden Teil des zweiten Impulses (RW2) dauert, und eine zweite Zeitdauer (y), die von dem Zeitpunkt des Erreichens des einstellbaren Schwellenwertes (S) durch den vom Scheitelwert gegen Bezugspotential strebenden Teil des ersten Impulses (RW1 bis zu dem Zeitpunkt des Erreichens des einstellbaren Schwellenwertes (S) durch den vom Scheitelwert gegen Bezugspotential strebenden Teil des zweiten Impulses (RW2) dauert, digital gemessen werden, daß danach die Meßwerte der Zeitdauern (x, y) aufsummiert werden und daß anschließend die Summe durch Zwei dividiert wird.

2. Verfahren nach Anspruch 1,
dadurch gekennzeichnet,
daß die erste und die zweite Zeitdauer (x, y) durch Aufsummieren periodischer Taktimpulse von gleicher Frequenz gemessen werden.

3. Verfahren nach Anspruch 1 oder 2,
dadurch gekennzeichnet,
daß die Impulse (RW1, RW2) aufeinanderfolgende Rückwandechoimpulse bei der Ultraschallprüfung von Werkstücken sind.

4. Vorrichtung zur Durchführung des Verfahrens nach Anspruch 1 oder 2,
dadurch gekennzeichnet,
daß ein Empfänger (10) für die Impulse (RW1, RW2) über Torschaltungen (12), die die zu messenden Impulse (RW1, RW2) freigeben, an nachgeschaltete Komparatoren (14, 16) angeschlossen ist, die jeweils bei Erreichen des Schwellenwertes (S) durch die gegen die Scheitelwerte bzw. von den Scheitelwerten gegen Nullpotential verlaufenden Teile der Impulse (RW1, RW2) ihr binäres Ausgangssignal ändern, daß die Ausgangssignale der Komparatoren je an einen Freigabeeingang eines Zählers (22, 24) angeschlossen sind, daß die Zähleingänge der Zähler von Taktimpulsen eines Taktgenerators (26) beaufschlagt sind und daß den Ausgängen der Zähler ein Addierer (28) und eine Dividieranordnung (30) nachgeschaltet sind.

5. Vorrichtung nach Anspruch 4,
<u>dadurch gekennzeichnet</u>,
daß die Dividieranordnung (30) ein mit dem Addierer (28) verbundener Rechner ist.

6. Vorrichtung nach Anspruch 4 oder 5,
<u>dadurch gekennzeichnet</u>,
daß der Empfänger (10), die Torschaltungen (12), die Komparatoren (14, 16), die Zähler (22, 24), der Addierer (28) und der Rechner (30) Bestandteile einer Ultraschall-Prüfeinrichtung sind, daß dem Rechner über eine weitere Eingabe (32) die Schallgeschwindigkeit vorgegeben wird und daß mit dem Rechner über einen Digital-Analog-Umsetzer (36) eine Einrichtung zur analogen Darstellung von Wandstärken verbunden ist.

**Claims:**

1. A method for determining the time interval between two symmetric, similar-formed pulses, triggering time-measuring operations on reaching adjustable threshold values resulting in measured quantities from which the pulse interval is found, characterized thereby that a first period (x) lasting from the moment of reaching the adjustable threshold value (S) by the leading edge of the first pulse (RW1) value till the moment of reaching the adjustable threshold value (S) by the leading edge of the second pulse (RW2), and a second period (y) lasting from the moment of reaching the adjustable threshold value (S) by the falling edge of the first pulse (RW1) till the moment of reaching the adjustable threshold value (S) by the falling edge of the second pulse (RW2), are measured digitally; that thereafter the measured quantities of the periods (x, y) are summed up; and that subsequently this sum is divided by two.

2. A method according to Claim 1, characterized thereby that the first period and the second period (x, y) are measured by summing up periodic time pulses of equal frequency.

3. A method according to Claim 1 or Claim 2, characterized thereby that the pulses (RW1, RW2) are sequential back face echo pulses in the ultrasonic testing of work pieces.

4. An apparatus for carrying out the method according to Claim 1 or Claim 2, characterized thereby that a receiver (10) for the pulses (RW1, RW2), via gate circuits (12) releasing the pulses (RW1, RW2) to be measured, is connected to comparators (14, 16), which each time by reaching the threshold value (S) of those edges of the pulses (RW1, RW2) either leading edges or falling edges, are changing their binary output signal; that the output signals of the comparators each are connected to a release input of a counter (22, 24); that the counting inputs of the counters are charged by time pulses of a time generator (26), and that an adding means (28) and a dividing arrangement (30) are connected after the outputs of the counters.

5. An apparatus according to Claim 4, characterized thereby that the dividing arrangement (30) is a computer connected to the adding means (28).

6. An apparatus according to Claim 4 or Claim 5, characterized thereby that the receiver (10), the gate circuits (12), the comparators (14, 16), the counters (22, 24), the adding means (28) and the computer (30) are components of an ultrasonic testing arrangement; that the sound velocity is preset on the computer by means of an additional input (32), and that an arrangement for the analog projection of wall thickness is connected to the computer via a digital-analog converter (36).

**Revendications**

1.- Procédé pour déterminer l'intervalle dans le temps de deux impulsions symétriques de forme analogue, qui lorsqu'elles atteignent une valeur de seuil réglable déclenchent des processus de mesure du temps, donnant des valeurs de mesure à partir desquelles l'intervalle entre les impulsions est calculé, procédé caractérisé en ce qu'on mesure numériquement une première période de temps (x) qui s'étend depuis le moment où la valeur de seuil reglable (S) est atteinte par la partie de la première impulsion (RW1) tendant vers la valeur maximale jusqu'au moment où la valeur de seuil réglable (S) est atteinte par la partie de la seconde impulsion (RW2) tendant vers la valeur maximale, et une deuxième période de temps (y) qui s'étend depuis le moment où la valeur de seuil réglable (S) est atteinte par la partie de la première impulsion (RW1) tendant depuis la valeur maximale vers le potentiel de référence, jusqu'au moment où la valeur de seuil réglable (S) est atteinte par la partie de la seconde impulsion (RW2) tendant depuis la valeur de seuil vers le potentiel de référence, en ce qu'ensuite les valeurs de mesure des périodes de temps (x, y) sont totalisées et en ce que finalement cette somme est divisée par deux.

2.- Procédé selon la revendication 1, caractérisé en ce que la première et la deuxième périodes de temps (x, y) sont mesurées par totalisation d'impulsions périodiques de synchronisation de même fréquence.

3.- Procédé selon la revendication 1 ou 2, caractérisé en ce que les impulsions (RW1, RW2) sont des impulsions successives d'écho de parois arrières lors du contrôle par ultra-sons de pièces d'oeuvre.

4.- Dispositif pour la mise en oeuvre du procédé selon la revendication 1 ou 2, caractérisé en ce qu'un récepteur (10) pour les impulsions (RW1, RW2) est raccordé par l'intermédiaire de circuits de portes (12), qui libèrent les impulsions (RW1, RW2) à mesurer, à des comparateurs (14, 16) branchés à la suite qui modifient respectivement leur signal de sortie lorsque la valeur de seuil (S) est atteinte par les parties des impulsions (RW1, RW2) s'étendant vers la valeur maximale ou bien de la valeur maximale vers le potentiel zéro; ces signaux de sortie des comparateurs étant respectivement appliqués à une entrée de libération d'un compteur (22, 24), les entrées de comptage du compteur étant sollicitées par les impulsions de synchronisations d'un générateur de rythme (26) et un totalisateur (28) et un dispositif diviseur (30) étant branchés à la suite des sorties du compteur.

5.- Dispositif selon la revendication 4, caractérisé en ce que le dispositif diviseur (30) est un calculateur combiné avec le totalisateur (28).

6.- Dispositif selon la revendication 4 ou 5, caractérisé en ce que le récepteur (10), les circuits de portes (12), les comparateurs (14, 16), les compteurs (22, 24), le totalisateur (28) et le calculateur (30) sont des parties constituantes d'un dispositif de contrôle par ultrasons, la vitesse du son étant prédéfinie au calculateur par l'intermédiaire d'une autre entrée (32) et un dispositif permettant la représentation analogique des épaisseurs de parois étant relié au calculateur par l'intermédiaire d'un convertisseur numérique-analogique (36).

0 091 563

Fig.1

Fig.3

1

Fig.2